# EUROPÄISCHE PATENTSCHRIFT

(11) **EP 1 086 488 B1**
(45) Veröffentlichungstag und Bekanntmachung des Hinweises auf die Patenterteilung: **03.01.2007**
(21) Anmeldenummer: 99936327.8
(22) Anmeldetag: 25.05.1999
(51) Int. Cl.: H01L 21/20, H01L 31/18, H01L 33/00

(54) **VERFAHREN ZUM HERSTELLEN VON HALBLEITERBAUELEMENTEN**
METHOD FOR PRODUCING SEMICONDUCTOR ELEMENTS
PROCEDE POUR PRODUIRE DES ELEMENTS SEMICONDUCTEURS

(30) Priorität: 29.05.1998 DE 19824142
(43) Veröffentlichungstag der Anmeldung: 28.03.2001
(73) Patentinhaber: Osram Opto Semiconductors GmbH & Co. OHG, 93049 Regensburg (DE)
(72) Erfinder: HÄRLE, Volker, D-93164 Waldetzenberg (DE)
(74) Vertreter: Epping - Hermann - Fischer
(86) Internationale Anmeldenummer: PCT/DE1999/001556
(87) Internationale Veröffentlichungsnummer: WO 1999/063582

(56) Entgegenhaltungen:
- EP-A- 0 681 315
- US-A- 4 614 564
- HARBISON J P ET AL: "TUNGSTEN PATTERNING AS A TECHNIQUE FOR SELECTIVE AREA III-V MBE GROWTH" JOURNAL OF VACUUM SCIENCE AND TECHNOLOGY: PART B,US,AMERICAN INSTITUTE OF PHYSICS. NEW YORK, Bd. 3, Nr. 2, Seite 743-745 XP000812109 ISSN: 0734-211X
- OZASA K ET AL: "DEPOSITION OF THIN INDIUM OXIDE FILM AND ITS APPLICATION TO SELECTIVE EPITAXY FOR IN SITU PROCESSING" THIN SOLID FILMS,CH,ELSEVIER-SEQUOIA S.A. LAUSANNE, Bd. 246, Nr. 1/02, Seite 58-64 XP000453839 ISSN: 0040-6090
- SEIKOH YOSHIDA ET AL: "SELECTIVE-AREA EPITAXY OF GAAS USING A NEW MASK MATERIAL FOR IN SITU PROCESSES" PROCEEDINGS OF THE INTERNATIONAL SYMPOSIUM ON GALLIUM ARSENIDE AND RELATED COMPOUNDS. (TITLE FROM 1994 ONWARDS: PROCEEDINGS OF THE INTERNATIONAL SYMPOSIUM ON COMPOUND SEMICONDUCTORS),GB,BRISTOL, IOP PUBLISHING, Bd. SYMP. 19, Seite 49-54 XP000366199
- PATENT ABSTRACTS OF JAPAN vol. 014, no. 207 (P-1043), 26. April 1990 (1990-04-26) & JP 02 046407 A (SEIKO EPSON CORP), 15. Februar 1990 (1990-02-15)
- O'SULLIVAN P J ET AL: "SELECTIVE-AREA EPITAXY FOR GAAS-ON-INP OPTOELECTRONIC INTEGRATED CIRCUITS (OEICS)" SEMICONDUCTOR SCIENCE AND TECHNOLOGY,GB,INSTITUTE OF PHYSICS. LONDON, Bd. 8, Nr. 6, Seite 1179-1185 XP000400531 ISSN: 0268-1242
- HENLE B ET AL: "IN SITU SELECTIVE AREA ETCHING AND MOVPE REGROWTH OF GAINAS-INP ON INP SUBSTRATES" PROCEEDINGS OF THE INTERNATIONAL CONFERENCE ON INDIUM PHOSPHIDE AND RELATED MATERIALS,US,NEW YORK, IEEE, Bd. CONF. 4, Seite 159-162 XP000341252 ISBN: 0-7803-0522-1

## Beschreibung

Die Erfindung bezieht sich auf ein Verfahren zum Herstellen von Halbleiterbauelementen, bei dem HF-lösliches Maskenmaterial verwendet wird. Es bezieht sich insbesondere auf ein Verfahren zum Herstellen von optoelektronischen Halbleiterbauelementen oder lateral integrierten Halbleiterbauelementen, bei denen elektrische und optoelektronische Halbleiterkomponenten kombiniert sind.

HF-lösliche Schichten auf einem Epitaxiesubstrat beispielsweise einem Halbleitersubstrat werden nach heutigem Stand der Technik naß- oder trockenchemisch außerhalb eines Epitaxiereaktors entfernt. Mit diesem Verfahren werden z.B. mittels selektiver Epitaxie oder Heteroepitaxie lateral integrierte Bauelemente hergestellt.

Bei der selektiven Epitaxie werden HF-lösliche Schichten zur Maskierung verwendet. Dabei wachsen im Epitaxiereaktor Schichten auf nicht maskierten Bereichen selektiv auf, wobei die maskierenden Schichten danach außerhalb des Reaktors naß- oder trockenchemisch entfernt werden. Zur weiteren Integration werden hierbei meistens noch weitere Lithographieschritte nötig. Ein solches Verfahren ist etwa in dem Dokument Patent Abstracts of Japan, Bd. 14, No. 207 (P-1043); & JP-A-2 046 407 beschrieben.

In der Heteroepitaxie werden direkte Halbleiter (Verbindungshalbleiter) auf ein Siliziumsubstrat aufgebracht. Dabei stellt das natürliche Oxid des Siliziums, SiO₂, welches durch den Kontakt des Substrates mit dem Sauerstoff der Luft entsteht, ein erhebliches Problem dar. Zum Entfernen dieser SiO₂-Schicht muß das Substrat einem Hochtemperaturschritt ausgesetzt werden. Dabei wird es auf ca. 900°C erhitzt.

Für beide Methoden wird das Substrat aus dem Reaktor ausgeschleust und der Luft ausgesetzt. Dabei wird das Substrat einer nicht kontrollierbaren Kontamination ausgesetzt. Durch mehrfaches Ein- und Ausschleusen werden diese Prozesse störanfällig, die Ausbeute an funktionsfähigen Bauelementen sinkt und die Herstellungskosten nehmen zu.

Bei der Heteroepitaxie werden z.B. elektrische und optoelektronische Komponenten integriert, wobei die elektrischen Komponenten bereits auf einem zu bearbeitenden Halbleitersubstrat vorhanden sind bevor die z.B. optoelektronischen hergestellt werden. Zum Entfernen des z.B. natürlichen Oxides des Siliziums, SiO₂ muß das Substrat einem Hochtemperaturschritt ausgesetzt werden, wodurch die elektrischen Bauelemente zerstört werden können.

Die Aufgabe der Erfindung besteht darin, bei der Schichtabscheidung mittels Epitaxie ein häufiges Ein- und Ausschleusen des Wafers und Hochtemperaturschritte so weit wie möglich zu vermeiden.

Diese Aufgabe wird durch ein Verfahren gemäß Anspruch 1 gelöst.

Vorteilhafte Weiterbildungen und vorteilhafte Verwendungen des Verfahrens sind Gegenstand der abhängigen Ansprüche 2 bis 10.

Das Abätzen der HF-löslichen Schichten erfolgt im Epitaxiereaktor durch Einleiten von Fluorwasserstoff (HF) oder einer instabilen Fluorverbindung. Die instabile Fluorverbindung zeichnet sich dadurch aus, daß sie durch Lichtanregung oder durch Erwärmung auf mindestens einhundert Grad Celsius zerfällt und Fluorwasserstoff freisetzt. Bei einigen Fluorverbindungen müssen zusätzlich andere Gase, sogenannte Tragergase, eingeleitet werden. Üblicherweise verwendet man H₂,N₂ oder Argon. Die Einleitung dieser Trägergase ist für instabile Fluorverbindungen, nicht aber für Fluorwasserstoff nötig.

Da viele Epitaxiereaktoren aus Quarzglas bestehen, welches dem zu ätzenden Oxid entspricht, müssen die Reaktorwände vor dem Ätzgas geschützt werden. Dies geschieht vorteilhafterweise durch Kühlung der Reaktorwände, da dadurch die Reaktivität der thermisch instabilen Gase dort deutlich herabgesetzt wird.

Mit dem erfindungsgemäßen Verfahren lassen sich HF-lösliche Substanzen direkt vor dem Epitaxieprozeß vom Substrat entfernen, wodurch Zeit und Kosten gespart werden können.

Durch Verwendung unterschiedliche HF-löslicher Maskenmaterialien mit unterschiedlichen Schichtdicken können im Epitaxiereaktor verschiedene Bauelemente hergestellt werden. Hierbei werden die unterschiedlichen HF-löslichen Maskenmaterialien in verschiedenen Ätzschritten abgehoben, ohne den Gesamtprozeß zu unterbrechen. Dabei können in mehrmaligen Überwachsschritten unterschiedliche Epitaxiematerialien epitaktisch abgeschieden werden. Durch geeignete Maskendefinition lassen sich Bauelemente gezielt abscheiden, wodurch spätere Lithograpieprozesse vorteilhafterweise eingespart werden.

Mit dem Verfahren können vorteilhafterweise schon vorprozessierte Halbleiterkomponenten (z. B. elektrische) mit weiteren Halbleiterkomponenten eines anderen Typs (z. B. optoelektronische) verknüpft werden. Dazu werden die schon vorhandenen Halbleiterkomponenten selektiv mit einer dicken, HF-löslichen Schicht bedeckt. Die Bereiche, die für die z. B. optoelektroischen Halbleiterkomponenten vorgesehen sind, sind dabei nur mit einer sehr dünnen, HF-löslichen Schicht überzogen. Durch einen insitu Ätzschritt werden dann diese Bereiche des Substrates freigelegt, um anschließend eine selektive Abscheidung der z.B. optoelektronischen Halbleiterkomponenten durchzuführen.

Das Verfahren und vorteilhafte Ausgestaltungen davon, werden im Folgenden anhand von vier Ausführungsbeispielen in Verbindung mit den Figuren 1a bis 4c näher erläutert.

Es zeigen:
Figuren 1a bis 1c eine schematische Darstellung eines ersten, allgemeinen Ausführungsbeispieles,
Figuren 2a bis 2d eine schematische Darstellung des Verfahrensablaufes für die Herstellung einer Laserstruktur (zweites Ausführungsbeispiel),
Figuren 3a bis 3c eine schematische Darstellung des Verfahrensablaufes gemäß einem dritten Ausführungsbeispiel und
Figuren 4a bis 4c eine schematische Darstellung des Verfahrensablaufes gemäß einem vierten Ausführungsbeispiel.

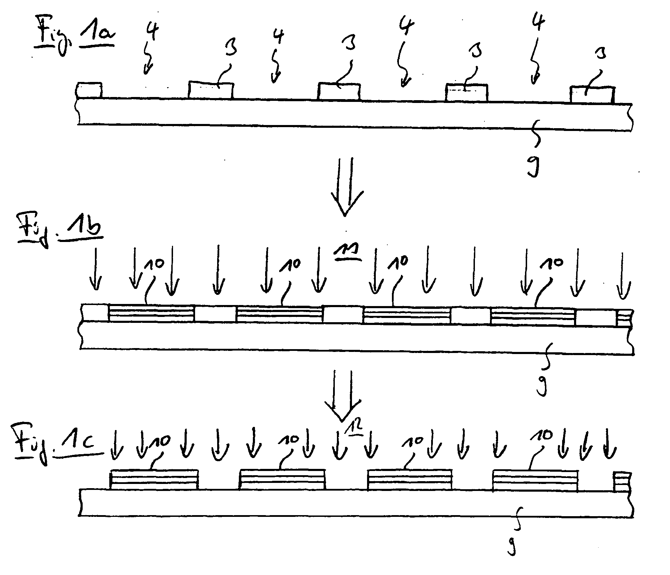

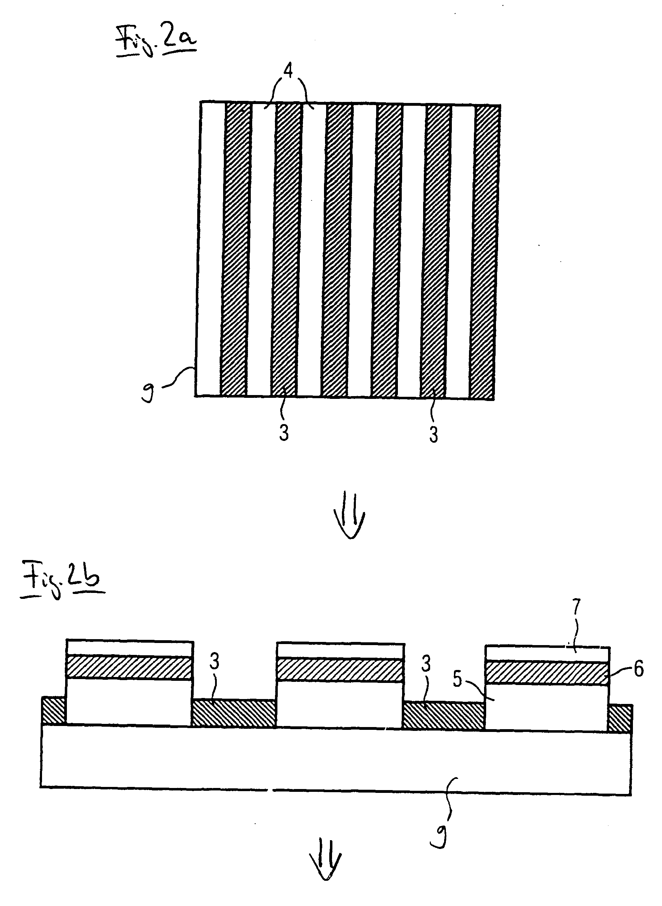

Bei dem Ausführungsbeispiel gemäß den Figuren 1a bis 1c wird zunächst ein Epitaxiesubstrat 9, auf dem eine aus einem HF-löslichen Material (z. B. SiO₂ oder SiₓNₓ) bestehende Maskenschicht 3 aufgebracht ist (Fig. la), in einen Epitaxiereaktor eingeschleust. Nachfolgend wird in Fenstern 4 der Maskenschicht 3 eine Halbleiterschichtenfolge 10 z. B. eines Halbleiterlasers beispielsweise mittels MOVPE (= metallorganische Dampfphasenepitaxie (engl.: metal organic vapour phase epitaxy)) epitaktisch auf das Epitaxiesubstrat abgeschieden (Fig. 1b). Der Abscheideprozeß ist in Fig. 1b durch die Pfeile 11 angedeutet.

Nachfolgend wird mittels Ätzen 12 mit einer Fluorverbindung (z. B. HF), die nach der Epitaxie in den Epitaxiereaktor eingeleitet wird, die zwischen den Halbleiterschichtenfolgen 10 befindliche Maskenschicht 3 entfernt (Fig. 1c). Die Prozeßtemperatur liegt vorzugsweise zwischen 50 und 500 °C. Danach kann der so hergestellte Wafer weiterverarbeitet werden.

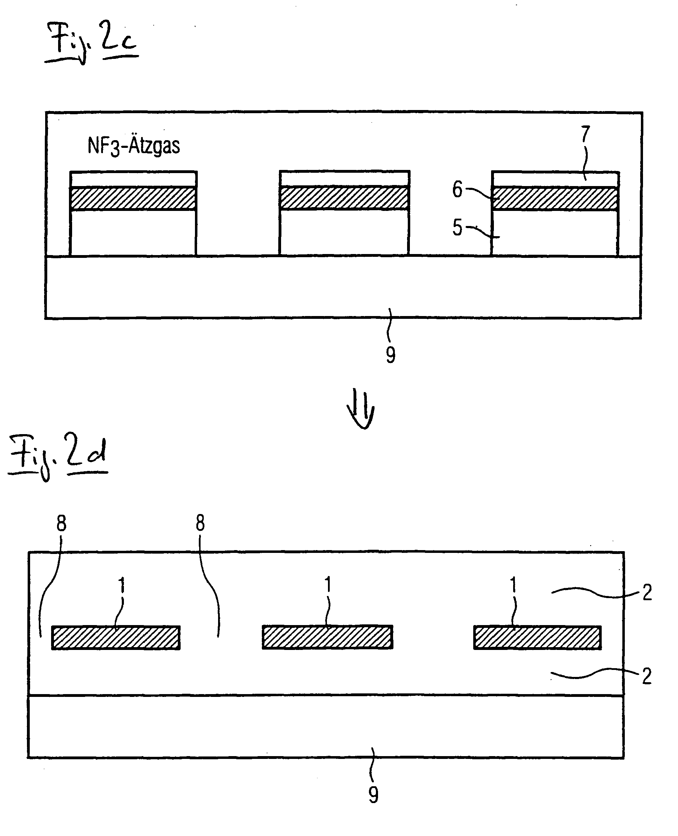

In den Figuren 2a bis 2d ist der Verfahrensablauf zum Herstellen einer Laserstruktur mit einem aktivem Bereich 1, einem ersten Wellenleiter 2 zur vertikalen Wellenführung und einem zweiten Wellenleiter 8 zur lateralen Wellenführung schematisch dargestellt.

Zur Erzeugung dieser Struktur wird eine HF-lösliche Maskenschicht 3 (SiO₂,SiₓNₓ) direkt auf ein Epitaxiesubstrat 9 aufgebracht (Fig. 2a). Danach wird in einem Epitaxiereaktor durch selektive Abscheidung in Fenstern 4 der Maskenschicht 3 eine Schichtfolge aus einer ersten Wellenleiterschicht 5, aktivem Bereich 6 und zweiter Wellenleiterschicht 7 aufgebracht (Fig. 2b). Die erste und zweite Wellenleiterschicht (5,7) bilden zumindest einen Teil des Wellenleiters 2 zur vertikalen Wellenführung.

Nachfolgend wird das Maskenmaterial durch Einwirken eines Ätzgases (z. B. NF₃) entfernt (Fig. 2c), das nach der Epitaxie beispielsweise zusammen mit einem Trägergas (z. B. H₂, N₂, Ar usw.) in den Epitaxiereaktor eingeleitet wird. Die Temperatur liegt hierbei vorzugsweise zwischen 50 und 500 °C.

In einem nachfolgenden Prozeßschritt wird dann, ohne den Wafer vorher aus dem Reaktor auszuschleusen, Wellenleitermaterial abgeschieden, derart, daß der Wellenleiter 2 zur vertikalen Wellenführung vervollständigt und der Wellenleiter 8 zur lateralen Wellenführung erzeugt wird (Fig 2d).

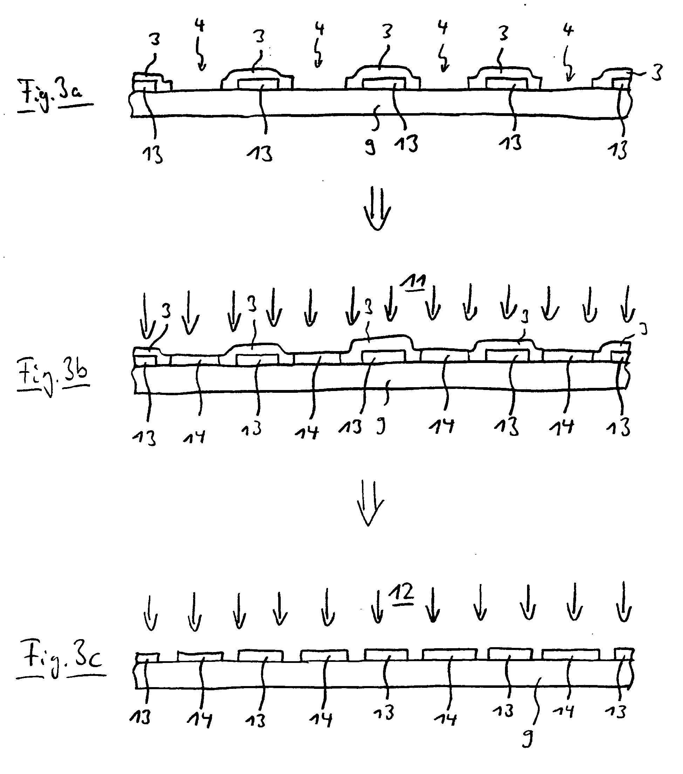

Bei dem in den Figuren 3a bis 3c schematisch dargestellten Verfahrensablauf zur Herstellung von lateral integrierten Halbleiterbauelementen, in denen elektrische Halbleiterkomponenten 13 (z. B. Transistoren, Dioden, Verstärkerstufen usw.; mit optoelektronischen Halbleiterkomponenten 14 (z. B. Laserdioden, optische Verstärker, Modulatoren, Leuchtdioden usw.) verknüpft sind, wird ein Epitaxiesubstrat 9, auf dem sich bereits die elektrischen Halbleiterkomponenten 13 befinden, eine HF-lösliche Maskenschicht 3 aufgebracht. Diese weist in den Bereichen, in denen später die optoelektronischen Halbleiterkomponenten 14 abgeschieden werden, Fenster 4 auf, in denen das Epitaxiesubstrat 9 freigelegt ist (Fig 3a). Dieser Wafer wird in einen Epitaxiereaktor eingeschleust, in dem dann in den Fenstern 4 die optoelektronischen Halbleiterkomponenten 14 auf dem Epitaxiesubstrat 14 abgeschieden werden (Fig. 3b). Nachfolgend wird die Maskenschicht 3 vermittels Einleiten einer Fluorverbindung in den Epitaxiereaktor entfernt (Fig. 3c), und der Wafer kann weiterprozessiert, z. B. mit weiteren Halbleiterschichten und/oder elektrischen Kontakten versehen werden.

Besonders bevorzugt wird bei dem oben beschriebenen Verfahren der Figuren 3a bis 3c auf ein Epitaxiesubstrat 9, auf dem sich bereits die elektrischen Halbleiterkomponenten 13 befinden, eine HF-löslichen Maskenschicht 3 aufgebracht, die auf den elektrischen Halbleiterkomponenten 13 dicker ist als in den Bereichen, in denen nachfolgend die optoelektronischen Halbleiterkomponenten 14 abgeschieden werden. Die dünnen Bereiche der Maskenschicht 3 werden in einem ersten Maskenentfernungsschritt im Epitaxiereaktor entfernt. Nachfolgend werden die optoelektronischen Halbleiterkomponenten auf die freigelegten Bereiche 4 mittels Epitaxie aufgebracht.

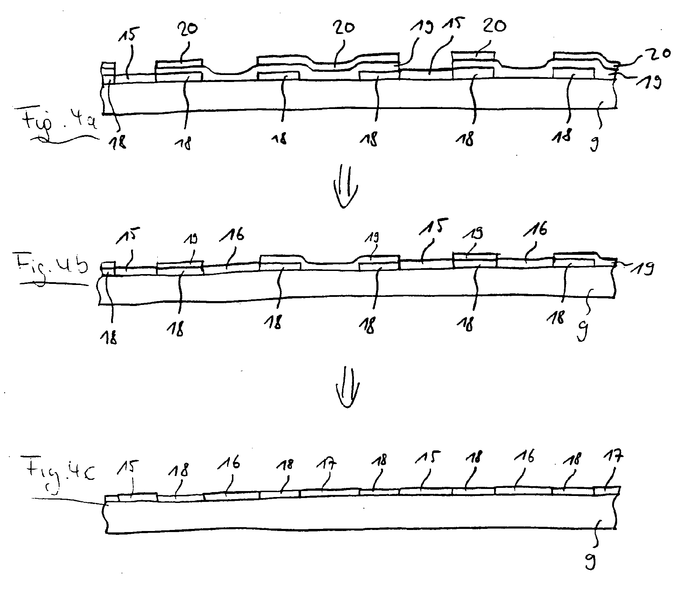

Das in den Figuren 4a bis 4c schematisch dargestellte Verfahren dient zum Herstellen von lateral integrierten Halbleiterbauelementen, in denen Halbleiterkomponenten 15,16,17 dreier unterschiedlicher Typen miteinander verknüpft sind. Hierzu werden ausgehend vom Epitaxiesubstrat 9 eine erste 18, eine zweite 19 und eine dritte HF-lösliche Maskenschicht 20 auf dem Epitaxiesubstrat 9 aufgebracht (Figur 4a). Diese können gleicher oder unterschiedlicher Zusammensetzung und/oder gleicher oder unterschiedlicher Dicke sein.

Die erste Maskenschicht 18, die zuerst auf das Epitaxiesubstrat 9 aufgebracht wird, weist überall dort ein Fenster auf, wo später eine Halbleiterkomponente 15,16,17 auf das Epitaxiesubstrat 9 aufgebracht wird. Die zweite Maskenschicht 19 weist nur überall dort ein Fenster auf, wo später eine Halbleiterkomponente 15 eines ersten Typs auf das Epitaxiesubstrat abgeschieden wird. Entsprechend weist die dritte Maskenschicht 20 nur überall dort ein Fenster auf, wo später eine Halbleiterkomponent des ersten 15 oder des zweiten Typs 16 abgeschieden wird.

Nach dem epitaktischen Aufbringen der Halbleiterkomponenten 15 des ersten Typs auf das Epitaxiesubstrat 9 wird die dritte Maskenschicht 20 und in deren Fenstern die zweite Maskenschicht 19 mittels Ätzen innerhalb des Epitaxiereaktors durch Einleiten einer Fluorverbindung entfernt (Figur 4b). Nachfolgend werden die Halbleiterkomponenten 16 des zweiten Typs epitaktisch auf dem Epitaxiesubstrat 9 abgeschieden und danach die restliche zweite Maskenschicht 19 mittels Ätzen innerhalb des Epitaxiereaktors durch Einleiten einer Fluorverbindung entfernt (Figur 4c). Erst danach werden die Halbleiterkomponenten 17 des dritten Typs auf das Epitaxiesubstrat 9 abgeschieden. Dieses Verfahren läßt sich auf eine beliebige Anzahl von Typen von Halbleiterkomponenten erweitern; lediglich die Anzahl der Maskenschichten und -ätzschritte müßte entsprechend der Anzahl der verschiedenen Typen von Halbleiterkomponenten angepaßt werden.

## Patentansprüche

1. Verfahren zum Herstellen von Halbleiterbauelementen, das folgende Verfahrensschritte aufweist:
a) Aufbringen einer HF-löslichen Maskenschicht (3) mit Epitaxiefenstern (4) auf ein Epitaxiesubstrat (9),
b) Epitaktisches Abscheiden (11) einer Halbleiter-Schicht oder -Schichtenfolge (10) auf den von den Epitaxiefenstern (4) freigehaltenen Bereichen des Epitaxiesubstrats (9) in einem Epitaxiereaktor und
c) Entfernen (12) des Maskenmaterials mittels einer Fluorverbindung,
**dadurch gekennzeichnet,**
**daß** als Fluorverbindung eine instabile Fluorverbindung in den Epitaxiereaktor, dessen Wände gekühlt sind, eingeleitet wird, die im Epitaxiereaktor zu Fluorwasserstoff zerfällt oder reagiert.

2. Verfahren nach Anspruch 1,
bei dem HF-lösliche Maskenschichten (3) unterschiedlicher Schichtdicken eingesetzt werden, die zu verschiedenen Zeiten des Verfahrensablaufs entfernt werden.

3. Verfahren nach Anspruch 1 oder 2,
bei dem HF-lösliche Maskenschichten unterschiedlicher Zusammensetzung als Maskenmaterial eingesetzt werden, die zu verschiedenen Zeiten des Verfahrensablaufs entfernt werden.

4. Verfahren nach Anspruch 2 oder 3,
bei dem zwischen den Schritten, bei denen die Maskenschichten entfernt werden, in die zu diesem Zeitpunkt freiliegenden Fenster Halbleitermaterial epitaktisch auf das Epitaxiesubstrat abgeschieden wird.

5. Verfahren nach einem der Ansprüche 1 bis 4,
bei dem die Substratoberfläche vor Prozeßbeginn im Epitaxiereaktor mittels Einleiten einer Fluorverbindung von HF-löslichen Schichten gereinigt wird.

6. Verfahren nach einem der Ansprüche 1 bis 5,
bei dem in Fenstern (4) der Maskenschicht (3), in denen das Epitaxiesubstrat (9) nicht von der Maskenschicht (3) bedeckt ist, eine Laserstuktur epitaktisch abgeschieden wird, die eine Schichtfolge mit einer ersten Wellenleiterschicht (5), mindestens einer aktiven Laserschicht (6) und einer zweiten Wellenleiterschicht (7) aufweist, und bei dem nach dem Entfernen der Maskenschicht in einem weiteren Epitaxieschritt Wellenleitermaterial (8) auf das Epitaxiesubstrat (9) abgeschieden wird.

7. Verfahren nach einem der Ansprüche 1 bis 5
zum Herstellen von lateral integrierten Halbleiterbauelementen, in denen erste Halbleiterkomponenten (13) mit zweiten Halbleiterkomponenten (14) verknüpft sind, die von den ersten Halbleiterkomponenten (13) verschieden sind, bei dem
a) auf ein Epitaxiesubstrat (9), auf dem sich bereits die ersten Halbleiterkomponenten (13) befinden, eine HF-lösliche Maskenschicht (3) aufgebracht wird, die in den Bereichen, in denen die zweiten Halbleiterkomponenten (14) abgeschieden werden sollen, Fenster (4) aufweist, und
b) in den Fenstern (4) die zweiten Halbleiterkomponenten (14) abgeschieden werden.

8. Verfahren nach Anspruch 7,
bei dem auf ein Epitaxiesubstrat (9), auf dem sich bereits die ersten Halbleiterkomponenten (13) befinden, eine HF-löslichen Maskenschicht (3) aufgebracht wird, die auf den ersten Halbleiterkomponenten (13) dicker ist als in den Bereichen, in denen nachfolgend die zweiten Halbleiterkomponenten (14) abgeschieden werden, die dünnen Bereiche der Maskenschicht (3) in einem ersten Maskenentfernungsschritt entfernt werden und nachfolgend die zweiten Halbleiterkomponenten (14) auf die freigelegten Bereiche aufgebracht werden.

9. Verfahren nach Anspruch 7 oder 8,
bei dem die ersten Halbleiterkomponenten (13) elektrische Halbleiterkomponenten und die zweiten Halbleiterkomponenten (14) optoelektronische Halbleiterkomponenten sind oder umgekehrt.

10. Verfahren nach einem der Ansprüche 1 bis 5
zum Herstellen von lateral integrierten Halbleiterbauelementen, in denen Halbleiterkomponenten aus einer Gruppe von n (n ∈ Natürliche Zahlen) verschiedenen Typen (15,16,17) miteinander verknüpft sind, bei der n Maskenschichten (18,19,20) auf dem Epitaxiesubstrat (9) aufgebracht werden, wobei die zuerst auf das Epitaxiesubstrat (9) aufgebrachte Maskenschicht (18) überall dort ein Fenster aufweist, wo eine Halbleiterkomponente beliebigen Typs abgeschieden wird und die x-te Maskenschicht(x ∈ {1,2,...,(n-1),n}) überall dort ein Fenster aufweist, wo eine Halbleiterkomponente eines Typs mit einer Ordnungszahl < x aufgebracht wird, und bei der nach Aufbringen der x-ten Halbleiterkomponente mittels Einleiten einer Fluorverbindung in den Epitaxiereaktor die (x+1)-ten Fenster freigeätzt werden.

## Claims

1. Method for producing semiconductor elements, which method has the following method steps:
a) application of an HF-soluble mask layer (3) comprising epitaxial windows (4) to an epitaxial substrate (9),
b) epitaxial deposition (11) of a semiconductor layer or layer sequence (10) on the regions of the epitaxial substrate (9) that are kept free by the epitaxial windows (4) in an epitaxy reactor, and
c) removal (12) of the mask material by means of a fluorine compound,
**characterized in that**
**in that** an unstable fluorine compound is introduced as fluorine compound into the epitaxy reactor, the walls of which are cooled, said unstable fluorine compound decomposing or reacting to form hydrogen fluoride in the epitaxy reactor.

2. Method according to Claim 1,
in which use is made of HF-soluble mask layers (3) having different layer thicknesses which are removed at different times of the method sequence.

3. Method according to Claim 1 or 2,
in which use is made of HF-soluble mask layers having different compositions as mask material which are removed at different times of the method sequence.

4. Method according to Claim 2 or 3,
in which, between the steps in which the mask layers are removed, semiconductor material is deposited into the windows that are uncovered at this point in time epitaxially onto the epitaxial substrate.

5. Method according to one of Claims 1 to 4,
in which the substrate surface is cleaned of HF-soluble layers before the beginning of the process in the epitaxy reactor by means of introducing a fluorine compound.

6. Method according to one of Claims 1 to 5,
in which a laser structure having a layer sequence comprising a first waveguide layer (5), at least one active laser layer (6) and a second waveguide layer (7) is deposited epitaxially in windows (4) of the mask layer (3) in which the epitaxial substrate (9) is not covered by the mask layer (3), and
in which waveguide material (8) is deposited onto the epitaxial substrate (9) after the removal of the mask layer in a further epitaxy step.

7. Method according to one of Claims 1 to 5
for producing laterally integrated semiconductor elements in which first semiconductor components (13) are combined with second semiconductor components (14) that are different from the first semiconductor components (13), in which
a) an HF-soluble mask layer (3) is applied to an epitaxial substrate (9), on which the first semiconductor components (13) are already situated, said mask layer having windows (4) in the regions in which the second semiconductor components (14) are intended to be deposited, and
b) the second semiconductor components (14) are deposited in the windows (4).

8. Method according to Claim 7,
in which an HF-soluble mask layer (3) is applied to an epitaxial substrate (9), on which the first semiconductor components (13) are already situated, said mask layer being thicker on the first semiconductor components (13) than in the regions in which the second semiconductor components (14) are subsequently deposited, the thin regions of the mask layer (3) are removed in a first mask removal step and the second semiconductor components (14) are subsequently applied to the uncovered regions.

9. Method according to Claim 7 or 8,
in which the first semiconductor components (13) are electrical semiconductor components and the second semiconductor components (14) are optoelectronic semiconductor components, or vice versa.

10. Method according to one of Claims 1 to 5
for producing laterally integrated semiconductor elements in which semiconductor components from a group of n (n ∈ natural numbers) different types (15, 16, 17) are combined with one another, in which n mask layers (18, 19, 20) are applied on the epitaxial substrate (9), the mask layer (18) applied first to the epitaxial substrate (9) having a window wherever a semiconductor component of arbitrary type is deposited and the x-th mask layer (x ∈ {1,2, ..., (n-1), n}) having a window wherever a semiconductor component of a type having an ordinal number < x is applied, and in which the (x+1)-th windows are etched free after the application of the x-th semiconductor component by means of introducing a fluorine compound into the epitaxy reactor.

## Revendications

1. Procédé de fabrication de composants semi-conducteurs, lequel procédé présente les étapes de traitement suivantes :
(a) application sur un substrat d'épitaxie (9) d'une couche de masque (3) soluble dans HF et dotée de fenêtres d'épitaxie (4),
b) dans un réacteur d'épitaxie, dépôt par épitaxie (11) d'une couche semi-conductrice ou une succession (10) de couches semi-conductrices sur les parties du substrat d'épitaxie (9) laissées libres par les fenêtres d'épitaxie (4) et
c) enlèvement (12) de matériau de masque au moyen d'un composé du fluor,
**caractérisé en ce que**
comme composé du fluor, on introduit dans le réacteur d'épitaxie dont les parois sont refroidies un composé instable du fluor qui se décompose ou qui réagit en fluorure d'hydrogène dans le réacteur d'épitaxie.

2. Procédé selon la revendication 1, dans lequel on utilise des couches de masque (3) solubles dans HF et d'épaisseurs différentes et dans lequel on les enlève à différents instants du déroulement du procédé.

3. Procédé selon les revendications 1 ou 2, dans lequel on utilise comme matériau de masque des couches de masque solubles dans HF et de compositions différentes et dans lequel on les enlève à différents moments du déroulement du procédé.

4. Procédé selon les revendications 2 ou 3, dans lequel, entre les étapes au cours desquelles les couches de masque sont enlevées, le matériau semi-conducteur est déposé par épitaxie sur le substrat d'épitaxie dans les fenêtres d'ouverture présentes à cet instant.

5. Procédé selon l'une des revendications 1 à 4, dans lequel, avant le début de l'opération, la surface du substrat est débarrassée des couches solubles dans HF par introduction d'un composé du fluor dans le réacteur d'épitaxie.

6. Procédé selon l'une des revendications 1 à 5, dans lequel on dépose par épitaxie dans les fenêtres (4) de la couche de masque (3) dans lesquelles le substrat d'épitaxie (9) n'est pas recouvert par la couche de masque (3) une structure laser qui présente une succession de couches constituée d'une première couche (5) de conducteur d'ondes, d'au moins une couche (6) à activité laser et d'une deuxième couche (7) de conducteur d'ondes et dans lequel, après enlèvement de la couche de masque, du matériau (8) de conducteur d'ondes est déposé sur le substrat d'épitaxie (9) au cours d'une autre étape d'épitaxie.

7. Procédé selon l'une des revendications 1 à 5, pour la fabrication de composants semi-conducteurs à intégration latérale, dans lesquels des premiers composants semi-conducteurs (13) sont associés à des deuxièmes composants semi-conducteurs (14) différents des premiers composants semi-conducteurs (13), et dans lequel :
a) sur un substrat d'épitaxie (9) sur lequel se trouvent déjà les premiers composants semi-conducteurs (13), on applique une couche de masque (3) soluble dans HF qui présente des fenêtres (4) dans les zones dans lesquelles les deuxièmes composants semi-conducteurs (14) doivent être déposés et
b) les deuxièmes composants semi-conducteurs (14) sont déposés dans les fenêtres (4).

8. Procédé selon la revendication 7, dans lequel on applique sur un substrat d'épitaxie (9) sur lequel se trouvent déjà les premiers composants semi-conducteurs (13) une couche de masque (3) soluble dans HF et plus épaisse sur les premiers composants semi-conducteurs (13) que dans les zones dans lesquelles les deuxièmes composants semi-conducteurs (14) sont ensuite déposés, les parties minces de la couche de masque (3) étant enlevées dans une première étape d'enlèvement du masque et les deuxièmes composants semi-conducteurs (14) étant ensuite déposés sur les zones libérées.

9. Procédé selon les revendications 7 ou 8, dans lequel les premiers composants semi-conducteurs (13) sont des composants semi-conducteurs électriques et les deuxièmes composants semi-conducteurs (14) sont des composants semi-conducteurs optoélectroniques ou inversement.

10. Procédé selon l'une des revendications 1 à 5, de fabrication de composants semi-conducteurs à intégration latérale, dans lequel des composants semi-conducteurs d'un premier groupe de n (n ∈ nombres naturels) différents types (15, 16, 17) sont associés les uns aux autres, dans lequel n couches de masque (18, 19, 20) sont appliquées sur le substrat d'épitaxie (9), la couche de masque (18) appliquée en premier lieu sur le substrat d'épitaxie (9) présentant une fenêtre partout où un composant semi-conducteur de type quelconque est déposé, la x-ième couche de masque (x ∈ {1, 2, ..., (n-1), n}) présentant une fenêtre partout où un composant semi-conducteur d'un type dont l'ordre est < x est appliqué, et dans lequel après application du x-ième composant semi-conducteur, les (x + 1)-ièmes fenêtres sont enlevées par introduction d'un composé du fluor dans le réacteur d'épitaxie.
